# EUROPEAN PATENT APPLICATION

(11) **EP 2 860 604 A1**
(43) Date of publication of application: **15.04.2015**
(21) Application number: 13306402.2
(22) Date of filing: 11.10.2013
(51) Int. Cl.: G06F 1/28, G01R 31/36

(54) **Method, device, server and system for accessing a service**

(71) Applicant: Gemalto SA, 92190 Meudon (FR)
(72) Inventor: Gullberg, Peter, 13705 La Ciotat (FR)

(57) **Abstract**

The invention relates to a method 30 for accessing a service.

According to the invention, a device 14 comprises or is connected to a battery 140. The method comprises the following steps. The device determines a status of a battery level, said battery status. The device generates a code depending upon the determined battery status, said battery code. The device sends to a server 18 data relating to the battery code 32. And the server determines based upon data relating to the battery code whether the battery has or has not a low level, as a battery status.

The invention also relates to corresponding device, server and system.

## Description

### Field of the invention:

The invention relates generally to a method for accessing a service. Furthermore, the invention pertains to a device for accessing a service. Moreover, the invention also relates to a server for accessing a service.

Finally, the invention pertains to a system for accessing a service as well.

### State of the art:

As known per se, a terminal or token, as device, comprises a battery that supplies power to at least electronic components that are included within the device.

After a certain device use, a device user is informed of a level of the battery power that is low.

When the battery (power) level is low, a device user calls a customer support. The device user asks the customer support for another device notably when the battery is not easily replaceable by the user herself or himself.

However, such a known solution implies to involve, on the one hand, the device user who shall call the customer support, and, on the other hand, a customer support that delivers to the device user a replacement device.

Thus, such a known solution is time consuming and costly.

There is therefore a need to deliver a new device for replacing a current device before that this latter runs out-of-battery while being efficient and cheap to keep access to a provided service(s).

### Summary of the invention:

The invention proposes a solution for satisfying the just herein above specified need by providing a method for accessing a service.

According to the invention, a device comprises or is connected to a battery. The method comprises the following steps. The device determines a status of a battery level, said battery status. The device generates a code depending upon the determined battery status, said battery code. The device sends to a server data relating to the battery code. And the server determines based upon data relating to the battery code whether the battery has or has not a low level, as a battery status.

The principle of the invention consists in that a device uses a battery (level) status, as input data, so as to produce a corresponding code that the device submits to a server. The server retrieves or generates the (original) status of the battery level based upon the received code. The server is thus informed of the battery status originating from the device that has issued the corresponding code.

The information relating to a battery status is therefore not clear data, i.e. encrypted data and/or part of input data of a code generation algorithm.

Access to the information relating to a battery status is protected since this latter is comprised, in a hidden manner, within the corresponding code.

Thus, the transmission of the information relating to a battery status is secure. The information relating to a battery status is only accessible to or verifiable by the server that is able to determine whether the device is or is not about to run out of battery.

There is no constraint on the time and place at which the device transmits the information relating to a battery status.

There is also no constraint on the technical means by which the device transmits the code. It may be through a wire or a wireless link while involving or not a device user to enter manually the code at the device.

The invention solution does not require any additional user intervention, so that the server accesses the information relating to a battery status.

Contrary to the herein above described known solution, to inform about a battery status, the invention does not need to involve a device user and a customer support while being secure.

Preferably, besides a determination of the battery status, the server authenticates the device user and/or the device based upon data relating to the battery code.

Thus, besides information about the battery status, the server also authenticates, in a simultaneous manner, the device or the device user on a basis of the received code relating to the battery status. In other words, the information about the battery status that is received at the server side is concomitant with information about the device authentication and/or the device user authentication.

According to a further aspect, the invention is a device for accessing a service.

According to the invention, the device comprises or is connected to a battery. The device is adapted to determine a status of a battery level, said battery status, to generate a code depending upon the determined battery status, said battery code; and to send data relating to the battery code.

As device, it may be, among others, a (user) terminal or any other device that is able to generate a code and to communicate the generated code.

As device, it may be a token that is able to generate a code and to communicate the generated code.

As token, it may include a dongle, a smart card, as removable token, to be coupled or not to a terminal or a chip intended to be fixed, possibly in a removable manner, to a token hosting device.

According still to a further aspect, the invention is a server for accessing a service.

According to the invention, the server is adapted to receive data relating to a code, the code depending upon a status of a battery level, said battery code, and to determine based upon data relating to the battery code whether the battery has or has not a low level, as a battery status.

According still to a further aspect, the invention is a system for accessing a service.

According to the invention, the system comprises at least one device and at least one server. The device comprises or is connected to a battery. The device is adapted to determine a status of a battery level, said battery status, to generate a code depending upon the determined battery status, said battery code, and to send data relating to the battery code. And the server is adapted to determine based upon data relating to the battery code whether the battery has or has not a low level, as a battery status.

### Brief description of the drawings:

Additional features and advantages of the invention will be more clearly understandable after reading a detailed description of one preferred embodiment of the invention, given as an indicative and non-limitative example, in conjunction with the following drawings:
- Figure 1 illustrates a simplified diagram of one exemplary embodiment of a system including a PC, a token and a remote server, the token including a battery and being adapted to provide the server with a code depending on a battery status, according to the invention;
- Figure 2 is a simplified scheme of one exemplary embodiment of a process for generating a cryptogram, as a battery code, depending on the battery status, that is used by the token and the server of figure 1; and
- Figure 3 represents a simplified message flow of one exemplary embodiment of a method implemented notably by the token and the server of figure 1, so that the server receives covertly the battery status issued from the token via the battery code.

### Detailed description:

Herein under is considered a case in which the invention method for accessing a service is implemented by, at a client side, a PC, as user terminal, in cooperation with a smart card, as token, and, at a server side, a distant server.

Within the present description, a token is a smart object or device that is intended to communicate with the outside world. The token is any electronic medium that may have different form factors.

However, the invention method for accessing a service may be implemented by a user terminal, as stand-alone entity. In other words, the terminal does not cooperate with any token, so as to issue a code depending upon a battery (level) status. According to such an embodiment (not represented), the terminal is adapted to carry out the functions that are described infra and carried out by the token and the terminal.

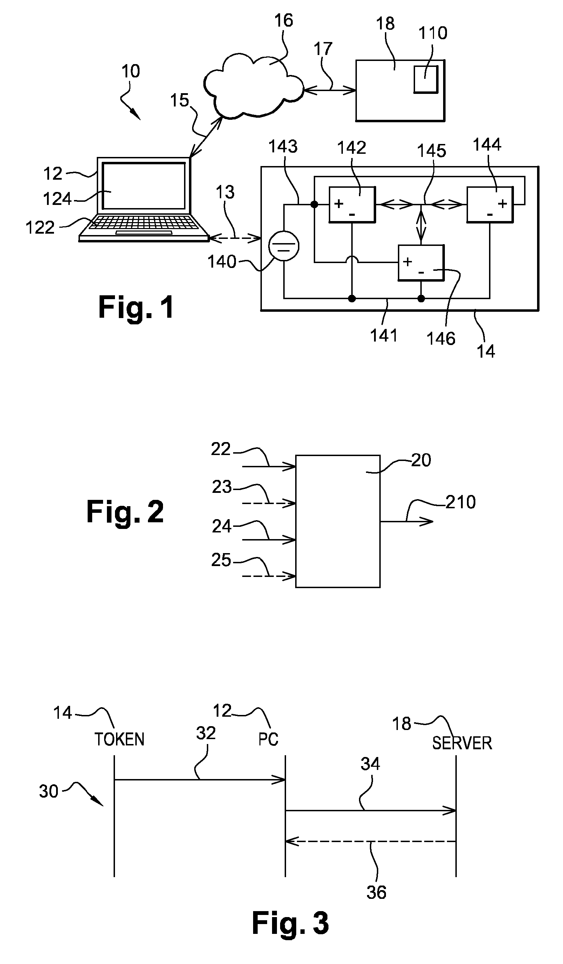

**Figure 1** shows a system 10 for accessing a service.

The system 10 comprises, at a client side, a PC 12, as terminal, a smart card 14, as token, and, at a server side, a remote server 18.

Instead of a user terminal, it may be any other device, like a token including a radio modem that allows accessing a network including or being connected to the remote server 18.

Instead of a PC, the terminal may include, among others, for example, a handset, a mobile phone, a smart phone, a PDA, an audio player, a video player, a media player, a game player, a laptop, a portable TeleVision (or TV) set, a tablet computer, a camera, a netbook and/or an electronic mobile equipment (e.g.: glasses, a watch).

The smart card 14 is portable.

For the sake of clarity and conciseness, the smart card 14 and the remote server 18 are termed herein after the token 14 and the server 18 respectively.

A user (not represented) is present in front of the PC 12.

The user carries or wears the token 14 that she/he owns.

The token 14 belongs preferably to the PC user.

The user may have subscribed to the server 18 one or several services, like an automatic token replacement service.

It is to be noted that only one client system, namely the PC 12 and the token 14, is represented for clarity reason. However, the server 18 is connected to a fleet of such client systems and/or client devices, like a terminal or a token that carries out the functions of the PC 12 and the token 14 that are specified infra.

The token 14 controls preferably access, through the PC 12, to the server 18, so that the PC user accesses a service provided by the server 18 (or another server).

According to another embodiment (not represented), each PC, as stand-alone device for accessing a service, controls, on its own, access to the server 18 or another server (not represented).

The PC 12 is connected, through one (or several) bi-directional wire or wireless link(s) 15, over one (or several) data communication network(s) 16, to the server 18.

Within the present description, the adjective "wireless" used within the expression "wireless link(s)" signifies notably that the link(s) include(s) one or several Radio-Frequency (or RF) links that may be short or long.

A Short Range (or SR) RF(s) may be fixed from around 2,4 GHz to around 10 GHz (for Ultra WideBand (or UWB), e.g. IEEE 802.15.4a), at 2,4-2,5 GHz with a range of about 10 m to 100 m (for Zigbee (e.g. IEEE 802.15.4), Wifi and Bluetooth or Bluetooth low energy (IEEE 802.15.1)) and/or other frequency value(s) allowing to communicate at a SR (typically from about 20 cm to 800 m).

The data communication network(s) 16 may include one or several SR radio-communication network(s).

A SR radio-communication network(s) may include a WLAN (acronym for "Wireless Local Area Network"), a Bluetooth, a Wifi, a Metropolitan Area Network (or MAN), a Worldwide Interoperability for Microwave Access (or WiMax) and/or a Wlreless BROadband (or WIBRO) radio-communication type technology(ies).

Such a SR radio-communication network list is not exhaustive but only for exemplifying purposes.

A Long Range (or LR) RF(s) may be fixed at several hundreds of MHz, for instance, around 850, 900, 1800, 1900 MHz, 2 GHz and/or more.

The data communication network(s) 16 may include one or several mobile radio-communication networks, as LR radio-communication network(s). The mobile radio-communication network(s) may be constituted by a Global Service for Mobiles (or GSM), a General Packet Radio Service (or GPRS), a Universal Mobile Telecommunications System (or UMTS), a Code Division Multiple Access (or CDMA) and/or a Long Term Evolution (or LTE) type network(s).

The mobile radio-communication network list, as LR radio-communication network, is not exhaustive but only for exemplifying purposes.

The data communication network(s) 16 may include or be connected to an Internet network.

The data communication network(s) 16 may be accessible, from a client side, over an Access Point (or AP), like a Wifi hotspot.

The PC 12 includes a microprocessor(s) (not represented), as data processing means, memories (not represented) and Input/Output (or I/O) interfaces (not represented).

The PC 12 includes preferably a keyboard 122 and a display screen 124, as Man Machine Interface (or MMI).

According to a particular embodiment (not represented), instead of two separate functional elements as MMI, the PC 12 includes a touch sensitive display screen that displays a virtual keyboard, when activated.

According to a first embodiment (not represented), the PC and the token, as disconnected token, are not physically connected.

According to a second embodiment (represented), the PC 12, as token hosting device, is coupled or connected to the token 14.

The token 14 is connected, through a bi-directional contact link 13, to the PC 12. The token 14 contact interface may be compliant with a standard(s), like ISO 7816.

According to another embodiment, instead of a contact link, the token 14 is connected, through a bi-directional contact-less link 13, i.e. an SR RF link, to the PC 12. Such an SR RF link is used for exchanging, between the PC 12 and the token 14, data at a SR distance. The RF link may be fixed, for instance, at 13,56 MHz for a Near Field Communication (or NFC) with a typical range up to around 20 cm, at 2,4-2,5 GHz with a typical range of around 10 m to around 100 m (for Zigbee (e.g. IEEE 802.15.4), Wi-Fi and Bluetooth or Bluetooth low energy (e.g. IEEE 802.15.1)), from around 2,4 GHz to around 10 GHz for UWB (e.g. IEEE 802.15.4a). The token 14 contact-less interface may be compliant with a standard of the type ISO 14 443.

The token 14, as device for accessing a service, includes a casing.

The token casing may include a token, such as a banking token, like e.g. an Europay Mastercard and Visa (or EMV) card reader that cooperates with a chip fixed to the banking token or a smart card, as second token (not represented). The second token may be physically connected or coupled to the banking token, as first token. According to such an embodiment, the first token includes a first microprocessor, as data processing means, and the second token includes a second microprocessor, as data processing means. According to such an embodiment, the second microprocessor carries out the security functions and runs an invention application for accessing a service that are specified below and carried out by the token 14.

The token casing includes one chip or several chips (not represented).

The token casing includes preferably a battery 140.

Alternatively (not represented), instead of incorporating a battery, a token chip is connected to a battery that is external to the token casing. According to such an embodiment, a token hosting device includes a battery that powers the token.

The battery 140 provides electrical power to operate the token 14 and possibly (an)other device(s), like another token, that is coupled or connected to the token 14.

The battery 140 may be of any type, like e.g. battery based on Lithium/manganese dioxide technology, such as CR2016 or CR2032 lithium button cell battery or ultra thin lithium/manganese dioxide battery for chip cards.

The battery 140 may be non-replaceable, i.e. to be used once, disposable (and preferably recyclable), or rechargeable, i.e. to be recharged and used multiple times.

The battery 140 is connected to the token chip, so as to provide token chip electronic components with electrical power.

A negative electrode of the battery 140 is connected, through a first wire 141, to the token chip electronic components.

A positive electrode of the battery 140 is connected, through a second wire 143, to the token chip electronic components.

The token chip includes one (or several) microprocessor(s) 142, as data processing means, one (or several) memory(ies) 144, as means for storing data, and one (or several) I/O interface(s) 146 that are internally all connected, through an internal bi-directional data bus 145, to each other.

The token I/O interfaces 146 allow communicating data from the chip internal components to the chip exterior and conversely.

The token casing may include a magnetic stripe (not represented).

The token casing may include a display screen (not represented).

A token microprocessor is able to let display data, like token user authentication data, that is preferably generated by the token 14.

The token 14 may have received, from an external device (not represented), like a second token, that is coupled or connected to the token 14, data to be displayed.

The external device may have previously generated the data to be displayed.

The token casing may include a keyboard with one or several keys (not represented).

The token user enters preferably data, like e.g. a Personal Identity Number (or PIN) and/or a One-Time-Password (or OTP), as token user authentication data by using the PC keyboard 122 or the token keyboard. A use of the token keyboard is secured since it is under the full token 14 control and thus trusted.

The token 14 is preferably equipped with a voltage sensor and/or a current sensor.

The token microprocessor 142 processes, controls and communicates internally data, with all other components incorporated within the chip and, through the I/O interfaces 146, with the chip exterior.

The token microprocessor 142 is able to get a battery level while determining a voltage and/or current output by the connected battery 140 with respect to a predefined output voltage and/or current.

According to the invention, the token 14 is adapted to determine a status of a battery level, as a battery (level) status. The battery status is determined by comparing the measured output voltage and/or current with respect to one or several predefined threshold values that represent(s) the remaining battery power. One or several predefined threshold values relating to a low level may be fixed while taking into account a desired level of accuracy and/or granularity. For instance, one predefined threshold value relating to a low level is fixed around 15% of the total battery power under which it is considered that the battery status is low.

According to another implementation, two or more predefined threshold values are fixed, e.g. a first low battery status is around 15% of the maximum battery power and a second low battery status is around 5% of the maximum battery power. The different battery statuses allow improving a battery management and/or a token 14 management, like a battery or a token to be more or less quickly replaced. For instance, e.g. if the second low battery status is detected, then a replacing battery and/or a replacing token is to be sent the day of the second low battery status reception. For instance, e.g. if the first low battery status is detected, then a replacing battery and/or a replacing token is to be sent within two days (or more) after the second low battery status reception. The different battery statuses may allow better anticipating a power cut of the token 14 and therefore a stock of products intended to replace at least the battery 140 to be replaced.

The token microprocessor 142 executes or runs one (or several) application(s). As application, it includes at least an invention application for accessing a service.

The token 14 is further adapted to generate a code based upon the battery status, as a battery code.

Alternately, instead of the token 14, a second device, like another token, coupled or connected to the token 14 is adapted to generate a code based upon the battery status, as a battery code. According to such an alternative embodiment, the token 14 provides the second device with the battery status.

The token 14 is further adapted to transmit to an external entity, like a remote server, data relating to the generated battery code.

Such a solution is user friendly, since the battery status is issued automatically and the token user does not need to be involved.

Such a solution may be or not transparent to the token user. The token user may be or not informed about a battery status.

The battery code may include token authentication data, such as a result depending upon a challenge and a secret key that is stored within the token 14 and at the server 18 side. The token authentication data depends on, besides a challenge that is received by the token 14, a battery status that the token 14 determines. The token user is not involved at all apart from a possible previous user authentication(s). In other words, at the same time, a receiver of such token authentication data is able, on the one hand, to authenticate the token and, on the other hand, to know about the battery status. For instance, when the battery status is low, instead of a first predetermined key relating to a high battery status, a second predetermined key relating to a low battery status is used for encrypting the challenge.

The battery code includes, in a preferred embodiment, token user authentication data, such as an OTP. The OTP depends thus upon a battery status that the token 14 (or another coupled or connected device) determines. The token user is involved to provide the token user authentication data without further being solicited specifically to inform about a battery status. In other words, at the same time, a receiver of such token user authentication data is able, on the one hand, to authenticate the token user and, on the other hand, to know about the battery status.

The token microprocessor 142 is preferably able to authorize or forbid to access one or several requested services, like e.g. a banking service and/or an on-line payment service.

The token microprocessor 142 executes preferably security functions.

The security functions may include an encryption/decryption process to be used before sending data to outside/after receiving data from outside, so as to protect access to data managed through and/or by the token 14.

The security functions may include an integrity verification process to be used after data reception, so as to detect whether received data is or is not modified or altered.

The security functions may include an integrity application process to be used prior to data sending, so as to allow a corresponding data addressee to detect whether data received by the token 14 is or is not modified or altered.

The security functions may include one or several token user authentication operations that have to be carried out, so as to operate the token 14.

As token user authentication operation, it may consist in verifying that data, such as an OTP, a PIN and/or a biometric print (like a finger print), that is submitted by an authorized user matches predetermined data which the token memory 144 stores securely.

As token user authentication operation, it may consist in submitting automatically user credentials to an entity that supports an application requested by the user. The user credentials may include a subscriber identifier(s), like a bank account number and one or several keys, like ki, allowing to identify and authenticate a subscriber to one or several servers. The user credentials are used for authenticating the token user to a concerned external entity(ies) that support(s) the application requested by the user. The user credentials may comprise an identifier and/or a password.

The security functions include preferably an on-line user authentication operation, so as to benefit, when the user is authenticated, from a requested service(s) offered from an external entity, like a remote server. The on-line user authentication operation may consist in submitting user authentication data, like an OTP, to be transferred from the token 14 and to be preferably provided by a token user.

The token memory 144 stores data relating to the concerned user, as personal user data. The user data may include a banking account number, a first name, a last name, a birth date, a private key, a PIN, biometric data (like a fingerprint(s), a facial print(s) and/or a iris print(s)) and/or other appropriate.

The token memory 144 stores preferably one or several keys, as secret data, that may be shared with another entity(ies), like the server 18. A first key may be used for a high battery status. One (or several) second key(s) may be used for one (or several) low battery status(es) respectively.

The token memory 144 stores preferably a public key relating to the server 18. The token 14 may use the server public key for generating a battery code.

Alternately, the token memory 144 stores a symmetric key shared with the server 18 to be used for generating a battery code.

The token memory 144 stores preferably one or several predefined threshold values below which the battery status is considered as being low.

When there are several predefined threshold values, the battery level is compared to at least two predefined threshold values, so as to determine between which predefined threshold values the battery level is present and associate a corresponding low battery status.

One battery status represents preferably a battery level that is higher, i.e. sufficiently charged, than a predefined threshold value, like 15 % of the maximum battery power. When the battery power is greater than the predefined threshold value, the battery status is high.

At least one battery status represents a battery level that is equal or lower, i.e. no more sufficiently charged, than a predefined threshold value, like 15 % of the maximum battery power. When the battery power is equal or lower than the predefined threshold value, the battery status is low.

Once determined the token memory 144 stores the battery status. The battery status is tracked by the token 14, as device for accessing a service.

The token memory 144 stores one or several applications, or termed applet when developed in an object oriented language, like Java (registered Trademark).

As application supported by the token 14, there is the application for accessing a service. The application for accessing a service may be an application for generating an OTP, like an applet termed Europay Mastercard Visa (or EMV) Chip Authentication Program (or CAP). Such an OTP generation application allows issuing an OTP, so as to authenticate once the token 14 that supports and executes this application.

The token memory 144 may store data relating to a Uniform Resource Identifier (or URI), a Uniform Resource Locator (or URL) and/or an Internet Protocol (or IP) address of an entity, like the server 18, through or by which a service is authorized to be accessed, which a request is to be sent to.

The server 18 may be a so-termed Over-The-Air (or OTA) or Over-The-Internet (or OTI) server 18.

The server 18 is accessible through the data communication network(s) 16.

The server 18 is connected, through a bi-directional wire link 17, to the data communication network(s) 16.

The server 18 is identified preferably by data stored within the token memory 144.

The server 18 follows a battery status of its client devices and/or systems, in particular when the battery status becomes low.

The server 18, as an addressee of a battery code to be sent from the token 14, may be identified by a URI, like a URL, a call phone number of a server, a video-conference call phone number of a server, an Internet address and/or an email address of a server relating to a service provider, as a server identifier(s).

The server 18 is hosted by a computer.

The server 18 may be operated by a bank operator, a mobile radio-communication network operator, a service provider and/or on its behalf.

As service provider, it may also be a company, as a transport operator, that manages a transport service, like a bus, a train, a plane and/or a loyalty service.

The server 18 supports, for instance, an application that, when running, allows providing a service(s) requested by a client device or client system user.

The server 18 may be accessible from the PC 12, as user terminal.

Alternatively, the server 18 is accessible directly (i.e. without any intermediary entity) from the token 14 that surveys preferably a status of its battery (level).

According to another embodiment (not represented), instead of a remote server 18, the server 18 is embedded within an entity, like a terminal or a token, and is locally accessible, i.e. up to 10 m via a short range Radio-Frequency (or RF) link, from the PC 12, as user terminal.

Alternately, instead of the server 18, another server (not represented) supports the application that the user desires to access. The server 18 is dedicated to running an application that allows authenticating the token 14 and possibly its user and managing a delivery of another battery and/or another token that will replace the current battery 140 and/or the current token 14 when a status of the token 14 battery 140 (level) is detected as being low at the client side.

The server 18 includes or is connected to a memory 110 storing a database.

The server 18 runs an application for managing the database.

The server 18 may communicate some information of the database to outside.

The database contains data that relates to a plurality of client devices including the token 14. The data includes preferably, for each client device, an identifier of an authorized server interlocutor, like a device identifier, a Primary Account Number (or PAN) or an International Mobile Subscription Number (or PIN), data relating to a status of a (power) level of an associated battery 140. By default, the data relating to a battery status matches a battery status high.

The server 18 may be able to delegate to another server (not represented) connected to the server 18 at least one security function, like data decryption, data encryption, signature, verification of data integrity, and/or application to data of an integrity algorithm.

The server 18 is adapted to receive data relating to a code depending on a status of a level of a (client) device (or system) battery, as a battery code.

The server 18 (or another entity connected to the server 18) is adapted to determine based on data relating to a battery code that is received whether the considered battery level is low or is not low, as a battery (level) status.

Once the server 18 receives a battery code from an identified client device and the server 18 has determined a corresponding battery status, the server 18 updates the corresponding data relating to a battery status associated with the identified client device.

The server memory 110 stores an algorithm 20 for generating a cryptogram that is detailed in relation with the figure 2.

The server memory 110 may store one first key relating to a high battery status and at least one second key relating to a low battery status.

To check battery code data, the server 18 determines firstly at least two values that are expected, namely a first value relating to a high battery status and at least one second value relating to a low battery status.

The server 18 may compare a received battery code with respect to a first battery code relating to the first value relating to a battery status high. If the battery code is equal to the first battery code relating to the first value relating to a battery status high, then the server 18 knows that the battery status is high. If the battery code is different from the first battery code relating to the first value relating to a battery status high, then the server 18 knows that the battery status is not high (and is therefore low). The precise low battery status has to be determined if there are several low battery statuses.

The server 18 compares a received battery code with respect to at least one second battery code relating to at least the second value relating to a low battery status respectively. If the battery code is equal to one second battery code relating to the second value or another value relating to a low battery status, then the server 18 knows that the battery status is low. If the battery code is different from all the second battery code(s) relating to the second value(s) relating to a low battery status, then the server 18 knows that the battery status is not low (and is therefore high).

When the battery status is determined as being low, the server 18 may be adapted to issue a notification or warning message to be addressed to the concerned client device, like the token 14. The token 14 may further provide the token user with a corresponding message. Such a message allows informing her/him about the determined battery status and possibly an action(s), like a replacement of the battery 140 and/or the token 14 by a replacing battery and/or a replacing token at the server 18 side.

The service provider or the operator monitoring the server 18 may also inform another entity(ies), like a server, when the token 14 is about to run out-of battery. The service provider or operator may decide when the server 18 (or another server) sends such a notification message either before or after the user knows that the token battery 140 is almost empty.

The server 18 may take one or several actions by ordering a new product(s), namely a battery or a token including a battery, for substituting to the battery 140 and/or the token 14 (with battery) to be addressed to the registered token user.

The server memory 110 may store, for each user, its user credentials, like a user identifier and/or a password. The user credentials are preferably to be submitted at a request for accessing a service supported through or by the server 18.

The server memory 110 may store at least one key to be used for encrypting and/or decrypting data to be exchanged with each server interlocutor, so as to prevent disclosure of the data thus exchanged. The server 18 is therefore able to protect data exchanged with its interlocutor. The key may be a public key related to either a PC 12 or a token 14, as server interlocutor.

The server memory 110 may store or access data relating to a private key relating to the server 18, data relating to a public key associated with the private key, and/or data relating to a shared key relating to an external entity, such as a token 14.

The public key relating to the server 18 may be shared between an external entity, like the token 14 (or the PC 12), and the server 18. The external entity is thus able to exchange data, in an encrypted manner, with the server 18.

The server 18 (or another server connected to the server 18) is able to decrypt encrypted data received from the token 14 by using a decryption key depending on a shared key and a predetermined decryption algorithm.

Alternatively, the server 18 is able to verify a battery code that is received from a client device, like the token 14. To verify the battery code, the server 18 generates, at its own side, a battery code by using predetermined input data and compares received data to the self generated battery code, as expected data. Only if the received data matches the expected data, the received data corresponds to a client device that is or is not about to run out of battery.

The server 18 may be arranged to authorize or forbid a requesting token user to access a service(s) managed by the server 18 or another entity, like another server (not represented) connected to the server 18.

The server 18 accesses rules for accessing the database to be satisfied by the user.

The rules for accessing the service may encompass a user profile(s) that is(are) eligible for accessing a service, such as a predetermined minimum bank credit amount, a predefined minimum age and/or other kind of access condition(s).

**Figure 2** is an exemplary embodiment of an algorithm 20 for generating a cryptogram, as a battery (status) code.

For the sake of clarity and conciseness, the algorithm 20 for generating a cryptogram is termed herein after the algorithm 20.

The algorithm 20 may be any mathematical function denoted by f. The mathematical function may be e.g. a random generation function.

The token 14, as client device, and the server 18 calculate or determine a battery code by using one and the same algorithm 20.

Alternately, instead of the token 14, a second device (not represented) that is coupled or connected to the token 14 determines a battery code by using the algorithm 20.

The token 14 firstly determines a battery (level) status.

The server 18 determines a battery code associated with each battery status.

The battery status may be coded or represented on one bit, like, e.g. "0" for high and "1" for low.

Alternatively, the battery status is coded on two (or more) bits, so as to provide a higher accuracy and a higher granularity (in particular for a low battery status), like, e.g.:
- "00" for high,
- "01" for low silent, and
- "10" for low warning.

If the battery status is low silent, then no warning message is to be provided, under the server 18 control and/or the token 14 control, to the token user.

If the battery status is low warning, then a warning message is preferably to be provided, under the server 18 control and/or the token 14 control, through a MMI included within or connected to the token 14, to the token user.

The token memory 144 and the server memory 110 store all the algorithm inputs.

A battery status 22 is used as one algorithm 20 input.

A key 24, as secret data, is preferably used as another algorithm 20 input. The key may be a key shared between the token 14 and the server 18.

Other optional parameter(s) may be used individually as an algorithm 20 input.

As optional parameter and variable factor, a time or a counter 23, like an event counter, may be used as another algorithm 20 input. Such a variable factor allows improving the security by randomizing an algorithm 20 output. If the token 14 is EMV compliant, then the counter may be an Application Transaction Counter (or ATC).

As optional parameter and freshness factor, a challenge 25 may be used as another algorithm 20 input, so as to avoid a replay attack. The challenge 25 originates from an external entity that desires to authenticate the token 14 and/or the token user.

The token 14 and the server 18 apply the predefined algorithm 20 input(s).

Once the calculation or computation has been achieved by running the algorithm 20, the token 14 and the server 18 get a code 210 depending on at least the battery status, as a battery code and the algorithm 20 output.

Such a battery code 210 may be, when the token 14 is EMV compliant, a resulting Application Cryptogram (or AC) produced from Generate AC.

Such a battery code 210 allows transporting a battery status, as merged within the battery code, preferably in a hidden manner.

Alternately, the battery code 210 includes, besides e.g. token authentication data, only added data relating to a battery status, as extended information within the algorithm 20 output.

Data relating to the battery code 210 may be represented in a binary number, a decimal number, an hexadecimal number or any other digit or character.

Furthermore, data relating to a battery status may be added, as clear data and extension data, while being included within a data block relating to the battery code 210 without impacting a value of the other data of the block.

The data relating to the battery code 210 may be further completed by data relating to a concerned low battery status (and not for a high battery status), like e.g. a single bit or a single digit (or more), while concatenating this latter to the generated battery code. Such a data completion allows simplifying a detection and a verification of a battery code presence and value, e.g. only for a low battery status. Such a data completion may be improved by adding further data relating to either a marking of the code presence or a completion to a pre-fixed length of a data block relating to the generated battery status code data.

If the generated data relating to the battery code 210 is token (user) authentication data, then such a data completion extends the token (user) authentication data. Such an extension generates a larger representation of the token (user) authentication data, as a data block, that is perceptible to the token user.

A battery level may be included, when the token 14 is EMV compliant, within the Card Data Object List (or CDOL) or the Card Verification Result (CVR).

The resulting data block may be reduced to a shorter data block, so as to be represented in a usual data block, like e.g. an OTP. Such a data block reduction may be a decimalization of part or all of the resulting data block.

To prevent the token user from perceiving the data completion, like e.g. an addition of a single bit or a single digit, as being static, the thus added data is either scrambled with neighbouring data (while reversing the order of their appearance) or timely shifted for its transfer.

**Figure 3** shows an example of a message flow 30 that involves notably the PC 12, the token 14 and the server 18, through or by which a token user desires to access a service.

It is assumed that the token 14 is a smart card that is inserted within a card reader equipping the PC 12 and the token 14 is used for authenticating the token user.

It is assumed that the server 18 authenticates a user of the token 14 while sending, through the PC 12, to the token 14 a challenge (not represented) generated at the server side. The server 18 uses the issued challenge and a key shared with the token 14, as the algorithm 20 inputs.

It is assumed that a battery code output by the algorithm 20 is represented by using e.g. six decimal digits.

It is assumed that the server 18 generates two cryptograms, as two battery codes and cryptographic responses, a first cryptogram value V1 relating to a high battery status by using a high battery status and a second cryptogram value V2 relating to a low battery status by using a low battery status.

The token 14 has preferably authenticated the token user by comparing successfully data, like a PIN and/or biometric data, entered by the token user and expected data stored within the token memory 144.

It is assumed that the token 14 controls the PC 12 to access securely the server 18 and that the token 14 determines that the battery 140 has a low battery status.

The token 14 generates an OTP, as user authentication data, based on the battery status, a received challenge and the algorithm 20 by using the key shared with the server 18. The key shared with the server 18 is either a symmetric private key stored by the token 14 and the server 18 or a public asymmetric key stored by the token 14 and a private asymmetric key stored by the server 18. The generated OTP is valid only once and depends therefore on the battery status.

The token 14 stores within its memory the generated OTP, as battery code.

The thus generated OTP reflects the considered battery status, e.g. the low battery status.

Then, the token 14 sends to the PC 12 a request for entering the OTP along with the generated OTP to be displayed and preferably a message to be displayed for entering data. The message to be displayed for entering data may be like e.g. "Please enter the OTP". The request is preferably accompanied with a request for sending data entered by the user to an identified server 18. The server 18, as addressee of the data entered by the user, is identified by an address stored by the PC, the token or an entry of the token user through the PC MMI or the token MMI.

Alternately, instead of requesting a transmission of the entered data to the server 18, the request is accompanied with a request for sending data entered by the user to the token 14. According to such an alternative, the token 14 checks whether the entered data matches the generated OTP, so as to control a sending of the entered data. If the entered data matches the generated OTP, then the token 14 sends to the server 18 the entered data. Otherwise, if the entered data does not match the generated OTP, the token 14 generates preferably another OTP while taking into account a new challenge (after a corresponding request to the server 18) and the low battery status and send to the PC 12 another request for entering the OTP along with the lastly generated OTP to be displayed and a message to be displayed for entering data to be displayed. According to an alternative, if the entered data does not match the generated OTP, the token 14 sends to the PC 12 another request for entering the OTP along with the generated OTP to be displayed and a message to be displayed for entering data to be displayed.

The PC 12 displays, through its display screen 124, the received OTP, as data relating to a battery code, and preferably the received message for entering data.

The token user enters preferably the OTP, as cryptographic response, by using the PC keyboard 122.

Alternatively, instead of using the PC MMI, a token display screen and a token keyboard are used for interacting with a token user and the PC 12 is only used for exchanging with the server 18.

According to another embodiment, the token 14 sends to the PC 12 a message 32 for requesting the PC 12 to send automatically (without involving the token user) the OTP to an identified server 18. The server 18, as addressee of the OTP, is identified by an address stored within the PC memory, the token memory 144 or an entry of the token user through the PC MMI (or a token MMI).

Prior to sending the OTP, the token 14 encrypts preferably the OTP.

Optionally, the PC 12 sends to the token 14 (not represented) the entered data, as OTP, and the token 14 authorizes the PC 12 to send to the server 18 the entered data only when this latter matches the provided OTP that the token 14 has generated.

Assuming that the entered data is the displayed OTP, the PC 12 sends to the server 18 the entered OTP 34, as a challenge response and cryptographic response, that reflects a battery status.

The PC 12 and the server 18 exchange by using a HyperText Transfer Protocol (or HTTP) or a HyperText Transfer Protocol Secure (or HTTPS) type protocol. The PC 12 and the server 18 may use any other data exchange protocol allowing to transfer data between them.

The PC 12 and the server 18 exchange preferably data in an encrypted manner, so as to protect access to the thus exchanged data. To encrypt/decrypt data, the PC 12 involves the token 14.

Once the server 18 receives the OTP, the server 18 determines based on the OTP, as battery code, whether the battery has or has not a low level, as battery status. The server 18 compares the submitted OTP, as cryptographic response, with respect to each of the expected battery codes, namely the first V1 and second V2 cryptogram values. Thus, the server 18 knows the battery status, in particular when this submitted OTP is the second cryptogram value V2.

Only if the submitted OTP does match one expected predetermined battery code that is(are) stored within the server memory 110, the server 18 authorizes to access the requested service. The server 18 may send to the PC 12, for instance, a message comprising data relating to a successful user authentication, like "transaction OK", as positive response to a request for accessing a service, like an on-line user authentication. Further to a recognition of an authorized user, the server 18 authorizes to continue a connection from the PC 12 to the server 18 (or another entity).

When the battery code matches a battery status that is low, the server 18 executes one or several actions, like at least a replacement of the battery 140 and/or the token 14.

Optionally, if the battery status is low (and there are several low battery statuses), then the server 18 further determines an emergency level for carrying out an action(s), e.g. a replacement of the battery 140 and/or the token 14, like an immediate mailing of the concerned product(s) or a shift of one or several days for the product mailing.

The server 18 may send to the PC 12 a message 36 including a notification of a device user about the considered battery status. Such a notification message 36 may include a request for displaying a warning message to be displayed. The warning message may be of the type "the battery power is low and you will receive a replacement battery/token" (possibly with a precise reception date or time period). Such a notification message may pass, through the token 14, so as to enhance the security. The security may be thus enhance by e.g. signing the notification message 36, adding notification message 36 integrity and/or encrypting its original content at the server 18 side and decrypting its content by the token 14.

The invention solution (for accessing a battery status) is secure since the battery status is transmitted covertly to the server 18, due to a use of data merged within the token user authentication data, as non-clear data. The received battery status is not tampered or forged and prevents against a user who pretends wrongly that the battery status is low.

Moreover, the invention solution is non-obtrusive and user friendly since such a battery status transmission does not need to involve the user but occurs while the token authentication data (and possibly the token user authentication data) is transmitted in a simultaneous manner.

There is no need to contact any customer support to get a replacement battery and possibly a replacement token.

The embodiment that is described is not intended to limit the scope of the concerned invention. Other embodiments may be given. As another embodiment example, the token 14, as a stand-alone entity and a device for accessing a service that carries out functions that are carried out by the token 14 and the PC 12 as described supra, is also able to access, on its own (i.e. without any intermediary terminal), the server 18. As still another embodiment, instead of the token 14, a user terminal, as a stand-alone entity, constitutes a device for accessing a service that carries out functions that are carried out by the token 14 as described supra.

## Claims

1. A method (30) for accessing a service,
**characterized in that**, a device (14) comprising or being connected to a battery (140), the method comprises the following steps:
- the device determines a status of a battery level, said battery status;
- the device generates a code depending upon the determined battery status, said battery code;
- the device sends to a server (18) data relating to the battery code (32); and
- the server determines based upon data relating to the battery code whether the battery has or has not a low level, as a battery status.

2. Method according to claim 1, wherein, besides a determination of the battery status, the server authenticates the device user and/or the device based upon data relating to the battery code.

3. Method according to claim 1 or 2, wherein the battery code further depends upon a time and/or a counter.

4. Method according to any of claims 1 to 3, wherein the data relating to the battery code is represented by at least one bit.

5. Method according to any of claims 1 to 4, wherein the device generates the battery code by using either a symmetric key or a public and private asymmetric key shared between the token and the server.

6. Method according to any of claims 1 to 5, wherein, prior to sending the data relating to the battery code, the method further comprises the following steps:
- the device or a token coupled or connected to the device displays or lets display a One-Time-Password, as the battery code, and
- the device user enters the One-Time-Password.

7. Method according to any of claims 1 to 6, wherein, after a determination of the battery status, the server sends to the device a message (36) for notifying a device user about the battery status.

8. A device (14) for accessing a service,
**characterized in that**, the device comprising or being connected to a battery (140), the device is adapted to:
- determine a status of a battery level, said battery status;
- generate a code depending upon the determined battery status, said battery code; and
- send data relating to the battery code.

9. A server (18) for accessing a service,
**characterized in that** the server is adapted to:
- receive data relating to a code (34), the code depending upon a status of a battery level, said battery code; and
- determine based upon data relating to the battery code whether the battery has or has not a low level, as a battery status.

10. A system (10) for accessing a service,
**characterized in that**, the system comprising at least one device (12, 14) and at least one server (18),
**in that**, the device comprising or being connected to a battery (140), the device is adapted to:
- determine a status of a battery level, said battery status;
- generate a code depending upon the determined battery status, said battery code; and
- send data relating to the battery code, and
**in that** the server is adapted to:
- determine based upon data relating to the battery code whether the battery has or has not a low level, as a battery status.
